Europäisches Patentamt

European Patent Office

Office européen des brevets

(11) Numéro de publication: **0 050 569**
**A1**

## DEMANDE DE BREVET EUROPEEN

(21) Numéro de dépôt: **81401631.7**

(22) Date de dépôt: **16.10.81**

(51) Int. Cl.³: **H 03 K 13/02**

(30) Priorité: **16.10.80 FR 8022104**

(43) Date de publication de la demande: **28.04.82**
**Bulletin 82/17**

(84) Etats contractants désignés: **AT BE CH DE GB IT LI LU NL SE**

(71) Demandeur: **MECILEC Société Anonyme française, 29, rue du Colisée, F-75008 Paris (FR)**

(72) Inventeur: **Guillemot, Philippe, 78, rue de l'Ouest, F-75014 Paris (FR)**

(74) Mandataire: **Weinstein, Zinovi et al, Cabinet Z. WEINSTEIN 20, Avenue de Friedland, F-75008 Paris (FR)**

(54) **Procédé et dispositif de conversion analogique-numérique incrémentale.**

(57) Un dispositif de conversion A/N comprend un échantillonneur-bloqueur (16) destiné à recevoir sur son entrée analogique (17) le signal analogique à numériser; des moyens de sommation de la tension de sortie de l'échantillonneur-bloqueur et se signaux de référence $+\Delta V$ et $-\Delta V$, respectivement; des comparateurs (12a à 13b) entre la tension d'entrée et la somme de la tension de sortie de l'échantillonneur-bloqueur et des signaux de référence $+\Delta V$ et $-\Delta V$, constituant un pas de quantification; et une logique (20a, 20b, 21) de commande de l'échantillonneur-bloqueur (16) et d'encrémentation et de décrémentation d'un compteur (22).

-1-

"Procédé et dispositif de conversion analogique-
numérique incrémentale".-

La présente invention a pour objet un convertisseur
analogique-numérique, permettant de fournir un
signal numérique représentatif d'une grandeur
d'entrée constituée par un signal électrique analogique. Elle est applicable chaque fois qu'il est
nécessaire de fournir une représentation numérique
d'une grandeur physique susceptible d'être mesurée
par des capteurs à sortie électrique. Elle est notamment utilisable dans des voltmètres et ampèremètres
numériques qui affichent sous forme numérique la
valeur d'une tension ou d'un courant. Mais elle est
naturellement utilisable aussi lorsque le signal
numérique de sortie est appliqué à un système de
traitement complexe.

Il existe déjà de très nombreux convertisseurs analogique-numérique, dits A/N, destinés à permettre
l'affichage de la grandeur d'un signal d'entrée sous
forme d'un nombre décimal directement lisible ou le
traitement ultérieur en logique binaire. Ces convertisseurs A/N appartiennent à plusieurs types, dont
les principaux sont à approximations successives,
à intégration à simple ou double rampe et stochastiques. Ces divers types de convertisseur ont chacun
des avantages et des inconvénients qui font que l'on

0050569

préfère l'un ou l'autre suivant l'impératif prépondérant, par exemple selon que l'on recherche essentiellement un temps de conversion court ou une résolution élevée. Mais les convertisseurs A/N connus présentent des caractéristiques communes qui constituent des inconvénients dans de très nombreux cas : le signal numérique de sortie est fourni sous forme d'un mot binaire ayant un nombre de bits significatifs fournis en parallèle qui est fonction de la résolution sur la pleine échelle. Lorsqu'on souhaite réaliser le convertisseur sous forme de circuits intégrés, la densité d'intégration augmente de manière exponentielle avec le nombre de bits significatifs, c'est-à-dire avec la résolution; enfin, le schéma de principe dépend des caractéristiques recherchées, d'où des problèmes de compatibilité lors de la mise au point d'un système; à résolution donnée, le prix du convertisseur augmente très vite avec la dynamique recherchée, par exemple lorsqu'on passe d'une résolution à huit bits à une résolution à seize bits.

L'invention vise à fournir un procédé et un dispositif de conversion A/N répondant mieux que ceux antérieurement connus aux exigences de la pratique, notamment en ce que : le schéma de principe reste immuable quelles que soient les caractéristiques recherchées (dynamique et résolution notamment), ce qui conduit à une compatibilité complète; il est réalisable sous forme de circuits intégrés avec le même nombre de composants et la même densité d'intégration quelles que soient les caractéristiques; et il fournit le signal de sortie sous forme d'impulsions en série.

Dans ce but, l'invention propose notamment un procédé de conversion A/N, caractérisé en ce qu'on compare un signal électrique analogique d'entrée à deux seuils séparés l'un de l'autre par un intervalle déterminé représentant un pas de quantification; on fait varier simultanément les deux seuils par incréments ou décréments égaux au pas, suivant que le signal est égal à l'un ou l'autre des seuils; on crée à chaque variation une impulsion affectée du signe + ou − suivant celui des seuils qui est atteint; et on totalise algébriquement en permanence le nombre des impulsions.

L'invention propose également un dispositif de conversion A/N d'un signal électrique, caractérisé en ce qu'il comprend un échantillonneur-bloqueur destiné à recevoir sur son entrée analogique le signal analogique à numériser; des moyens de sommation de la tension de sortie de l'échantillonneur-bloqueur et de signaux de référence $+\Delta V$ et $-\Delta V$, respectivement; des moyens permettant de comparer, à la tension d'entrée, la somme de la tension de sortie de l'échantillonneur-bloqueur et des signaux $+\Delta V$ et $-\Delta V$, constituant un pas de quantification; et des moyens logiques reliés aux moyens de comparaison, destinés à émettre une impulsion de mémorisation de la tension d'entrée par l'échantillonneur-bloqueur lorsque les moyens de comparaison constatent une égalité et simultanément, à émettre une impulsion affectée du signe + ou du signe − suivant le cas.

Le dispositif peut comporter une seule voie fonctionnant en alternance avec les valeurs $+\Delta V$ et $-\Delta V$. Mais il est de beaucoup préférable d'utiliser deux voies de mesure correspondant à des "fenêtres" de même

valeur absolue $\Delta V$, mais correspondant à des signes opposés. Dans tous les cas, chaque égalité avec $\pm \Delta V$ détectée par les moyens de comparaison provoquera l'émission d'une impulsion affectée du signe convenable; des moyens de comptage algébrique,, tels qu'un compteur-décompteur, seront prévus pour totaliser les impulsions et fournir un nombre qui est une représentation linéaire de la grandeur électrique d'entrée.

L'invention sera mieux comprise à la lecture de la description qui suit d'un mode particulier de réalisation, donné à titre d'exemple non limitatif. La description se réfère aux dessins qui l'accompagnent, dans lesquels :

La figure 1 est un schéma de principe d'un mode particulier de réalisation.

Les figures 2, 3 et 4 sont des chronogrammes illustrant le fonctionnement du dispositif de la figure 1.

La figure 5 est un schéma synoptique d'un dispositif conforme au schéma de la figure 1.

La figure 6, similaire à la figure 1, montre une variante.

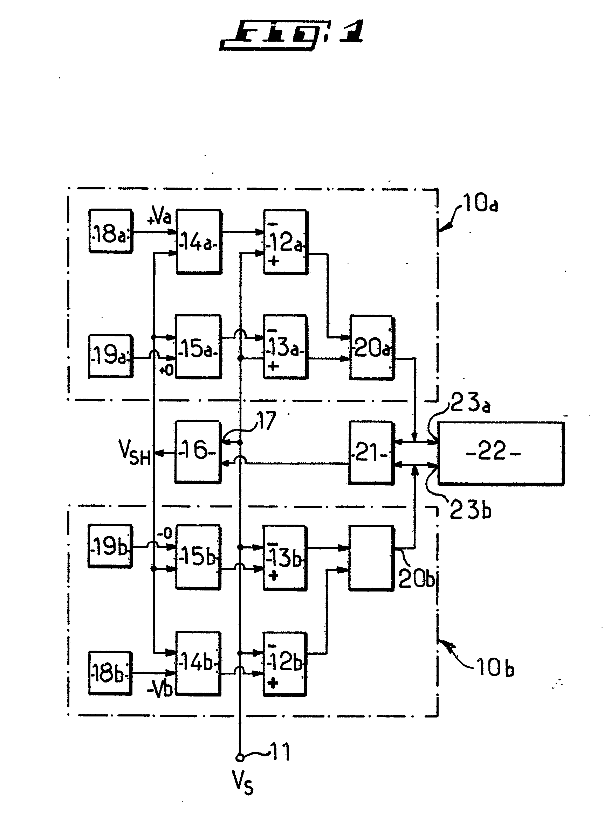

Le dispositif montré en figure 1 comprend deux voies parallèles 10a et 10b de même constitution, qui interviennent respectivement lors de l'augmentation et de la diminution du signal analogique Vs, appliqué sur une entrée 11.

On décrira tout d'abord la voie 10a. Elle comporte deux comparateurs 12a et 13a dont les entrées + sont reliées à l'entrée 11 de réception du signal Vs, que l'on supposera être une tension. Les entrées - des comparateurs 12a et 13a sont reliées à des moyens sommateurs respectifs 14a et 15a. Chacun de ces sommateurs reçoit le signal de sortie $V_{sh}$ d'un échantillonneur-bloqueur 16, désigné sur la figure 1 par son abréviation habituelle S & H. L'entrée analogique 17 de cet échantillonneur-bloqueur 16 est reliée à l'entrée 11.

Les moyens de sommation 14a et 15a reçoivent également des tensions de référence fournies par des générateurs respectifs 18a et 19a. Le générateur 19a fournit une tension que l'on appellera 0+, qui, en théorie, est nulle mais, en fait, doit être ajustable pour compenser la tension de décalage éventuel des moyens de sommation 15a ou même du comparateur 13a. Le générateur 18a de son côté fournit une tension positive $+V_a$ , dont la valeur absolue $\Delta V$ correspond à la résolution du dispositif.

La seconde voie 10b comporte les mêmes éléments que la voie 10a, affectés, sur la figure 1, de l'indice b au lieu de a. Toutefois, les générateurs de référence 18b et 19b fournissent respectivement des tensions stabilisées 0- et $- V_b$ , correspondant encore à la résolution $\Delta V$. La sortie des moyens de sommation 14b et 15b attaque cette fois la sortie + des comparateurs respectifs 12b et 13b, dont l'entrée - reçoit le signal Vs.

Les voies 10a et 10b comportent de plus chacune une logique 20a ou 20b qui sera généralement une bascule. Les bascules attaquent en parallèle l'entrée de blocage de l'échantillonneur-bloqueur 16 par l'intermédiaire d'une porte 21 et attaquent également des
moyens 22 de comptage incrémental et décrémental.
Les entrées d'incrémentation 23a et de décrémentation 23b seront respectivement attaquées par les
logiques 20a et 20b.

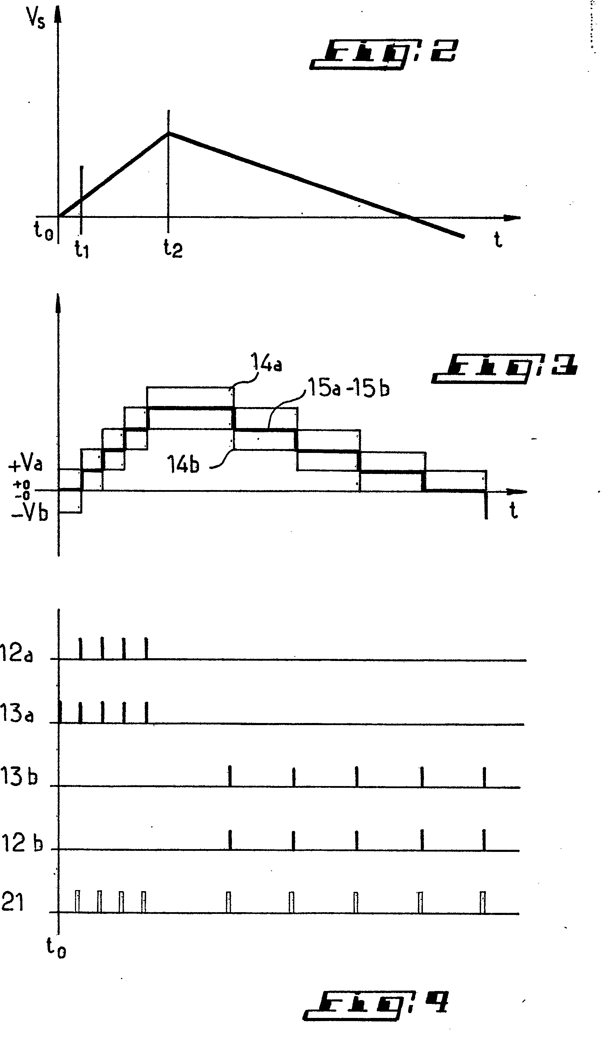

Le fonctionnement du dispositif dont la constitution
de principe est donnée en figure 1 sera maintenant
décrit en faisant référence aux figures 2, 3 et 4.

Dans l'état initial du dispositif, la tension
d'entrée Vs sera supposée nulle. Cette condition peut
toujours être remplie en interposant, entre la source
de tension à mesurer et l'entrée 11, un circuit de
remise à zéro en cas d'absence de signal d'entrée. La
sortie des logiques 20a et 20b est à 1. Ce 1 est transmis par la porte OU 21 à l'entrée de commande de
l'échantillonneur-bloqueur 13, qui est alors transparent au signal appliqué sur son entrée.

Les signaux délivrés par les moyens de sommation à
cet instant $t_0$ sont alors respectivement +Va pour
14a, $0^+$ pour 15a, $0^-$ pour 15b et -Vb pour 14b avec
$|Va| = |Vb|$ . La tension de sortie $V_{SH}$ de l'échantillonneur-bloqueur 16 est égale à Vs, donc à zéro.

Les comparateurs reçoivent alors d'une part Vs = 0;
et +Va pour 12a; 0+ pour 13a; 0- pour 13b; -Vb pour
12b.

Les moyens de comparaison 12a et 12b ne détectant pas
d'égalité, leur sortie reste au niveau logique "0" .
Au contraire, les moyens de comparaison 13a et 13b
détectent l'égalité. Va = +0 pour 13a, Vb = -0 pour 13b
et leur sortie passe au niveau logique "1" .

Les logiques 20a et 20b transmettent alors un signal logique, par exemple "0" à la porte OU 21 qui donne alors un ordre de blocage, par exemple un "0" binaire, à l'échantillonneur-bloqueur 16. Celui-ci jusque-là transparent au signal Vs, donc en état d'échantillonnage, se verrouille et mémorise ainsi la valeur analogique Vs du moment, ici Vsh = Vs = 0 .

On voit que les comparateurs 12a-13a constituent une "fenêtre" de détection par valeurs positives dont la référence basse est délivrée par les moyens de sommation 15a et la référence haute est délivrée par les moyens de sommation 14a.

De même, les moyens de comparaison 13b et 12b constituent une "fenêtre" de détection par valeurs négatives symétriques de la précédente.

Si l'on suppose maintenant que la tension Vs augmente, comme illustré sur la figure 2, les moyens de comparaison 13a et 13b ne détectent plus d'égalité. Leur sortie revient au niveau logique 0. L'état des moyens de comparaison 12a et 12b reste inchangé. Les logiques 20a et 20b restent dans leur état précédent et, par conséquent, l'échantillonneur-bloqueur 16 maintient, sur sa sortie analogique, le signal Vsh = 0, valeur précédemment mémorisée. Les moyens de comptage 22 restent dans leur état initial, c'est-à-dire à 0.

Lorsque le signal d'entrée Vs atteint la valeur +Va, à l'instant $t_1$ , les moyens de comparaison 12a détectent une égalité. Leur sortie passe à l'état 1 et provoque le basculement de la logique 20a, ce qui provoque l'apparition d'une transition de sortie, de l'état 0 à l'état 1. Cette transition est simultanément :

- appliquée aux moyens de comptage 22 qui s'incrémentent de 1,

- transmise par la porte 21 à l'entrée de commande de l'échantillonneur-bloqueur 16. Ce signal substitue la nouvelle valeur du signal mesuré Vs = +Va à l'anci l'ancienne valeur sur la sortie analogique de l'échantillonneur-bloqueur. Cette nouvelle valeur Vsh = Vs = Va + est appliquée aux moyens de sommation 14a, 15a, 14b, 15b. Les moyens de comparaison 13a, 13b, 12b n'ayant pas détecté d'égalité n'ont pas changé d'état.

On voit qu'à la suite de cette commande de l'échantillonneur-bloqueur 16, les moyens de sommation fournissent respectivement sur leur sortie les valeurs +2 Va pour 12a, +Va pour 13a, +Va pour 13b et 0 pour 12b. Les références appliquées aux moyens de comparaison sont décalées de +Va et sont maintenant celles indiquées par le premier échelon des courbes en escalier 12a, 13a-13b et 12b sur la figure 3.

Ce décalage des références de tension provoque le basculement du comparateur 12a, dont la sortie revient à l'état logique 0 dès qu'il ne détecte plus une égalité et du comparateur 13a qui détecte au contraire une égalité et dont la sortie passe de l'état 0 à l'état 1.

La logique 20a transmet de nouveau un signal logique "0" qui donne un ordre de blocage à l'échantillonneur-bloqueur 16. Il y a lieu de constater que la sortie du comparateur 13a passe à l'état "1" immédiatement après que le comparateur 12a change d'état logique. La logique 20a transmet alors un ordre d'échantillonnage à l'échantillonneur-bloqueur 16 aussitôt après le changement d'état du comparateur 13a,

ceci permettant d'accroître la rapidité d'échantillonnage du dispositif.

Les comparateurs 13b et 12b restent par contre dans
le même état. Bien que le comparateur 13b constate
une égalité entre ses deux entrées, il ne change
pas d'état car il est conçu pour ne basculer que
lorsque le signal Vs est croissant (détection par
valeur négative). Quant au comparateur 12b, il ne
constate pas d'égalité.

On voit que l'une des entrées de la logique 20a
passe de 1 à 0 et que l'autre passe de 0 à 1. Sa
sortie bascule de l'état 1 à l'état 0 et en conséquence la sortie de la porte 21 passe à 0, ces deux
entrées étant à l'état zéro. L'échantillonneur-
bloqueur 16 se trouve bloqué, mémorise la valeur
Vs = +Va présente sur son entrée analogique et la
fournit sur sa sortie Vsh.

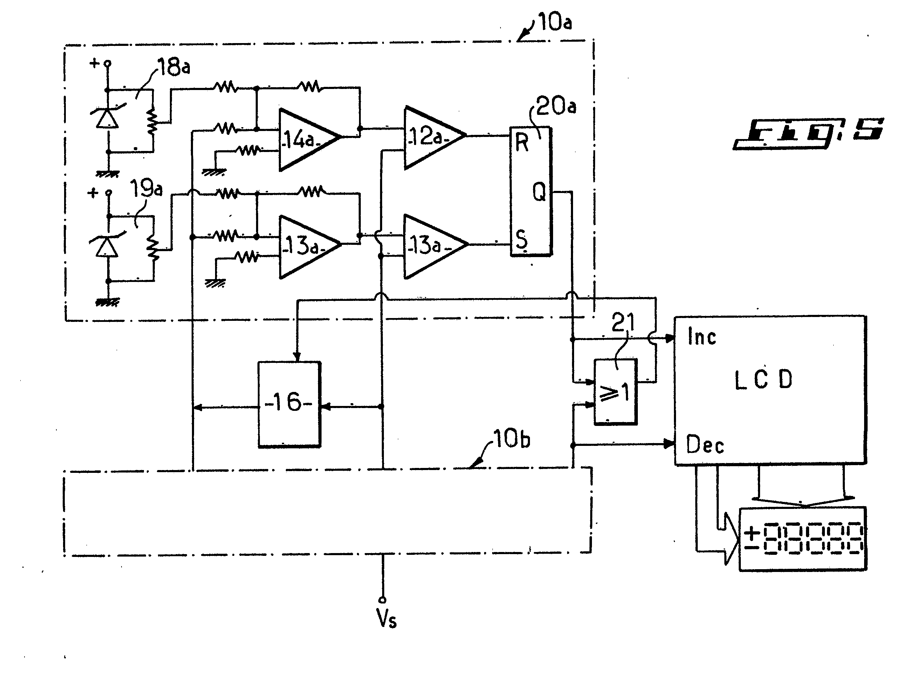

Le fonctionnement se poursuit ainsi avec décalage
successif des références dans le sens croissant, aussi
longtemps que la tension Vs augmente. Lorsqu'au
contraire la tension Vs décroît, à partir de l'instant
$t_2$ , c'est la seconde voie 10b du dispositif qui
intervient pour décaler les références par pas successifs $\Delta V$ dans le sens décroissant. Les signaux qui
apparaissent sur les sorties des comparateurs 12a, 13a,
12b et 13b ont l'allure indiquée sur les lignes correspondantes de la figure 4. La dernière ligne de cette
figure montre les signaux rectangulaires brefs appliqués sur l'entrée de commande de l'échantillonneur-
bloqueur 16 par la porte 21.

Le dispositif dont la constitution de principe est
donnée en figure 1 peut être réalisé sous des formes très diverses. On connaît en effet de nombreux composants électroniques capables de remplir les fonctions requises de chacun des composants.

Les moyens de référence 18a et 18b peuvent être de n'importe quel type capable de fournir une tension de référence stabilisée avec précision; il peut notamment s'agir de diodes, de diodes Zener et de circuits générateurs de tension stabilisés et présentant une compensation de température.

Les moyens de sommation 14a, 15a, 15b, et 14b, destinés à fournir la somme de deux signaux analogiques, peuvent être constitués par un circuit à transistors discrets des amplificateurs opérationnels, etc.

Les comparateurs 12a, 13a, 13b et 12b ont pour fonction de fournir un signal logique de sortie qui a une valeur lorsque les signaux analogiques d'entrée sont égaux et une autre valeur lorsque ces signaux sont différents : il existe de très nombreux circuits remplissant cette fonction.

Les logiques 20a et 20b doivent répondre à une table de vérité qui dépend de la constitution de la porte 21 et de l'échantillonneur-bloqueur 16. En général, on choisira une logique répondant à la table de vérité ci-dessous (cas de la logique 20a) ou à son inversion logique.

| Entrées | | Sorties S |
|---|---|---|
| 0 | 0 | Etat précédent mémorisé |
| 1 | 0 | 1 |
| 0 | 1 | 0 |

La porte 21 est de constitution classique : sa table de vérité est choisie en fonction de celles des logiques 10a et 20b. Enfin, les moyens de comptage 22 sont de n'importe quel type permettant de totaliser le nombre d'incréments et le nombre de décréments reçus sur ses entrées. Ils seront généralement associés à des moyens d'affichage numérique.

On voit que le dispositif permet de choisir un pas de quantification $\Delta V$ quelconque, qui peut notamment représenter une unité de tension, par exemple 1 mV, 10 mV, 1 V, etc. La sortie des moyens de comptage 22 fournira alors une valeur directement lisible en unité courante. Ainsi, il est possible de choisir un pas de quantification $\Delta V$ le plus petit possible, ce qui correspond à une résolution plus élevée du dispositif.

Il faut toutefois remarquer que les moyens de comptage doivent affecter un signe à la valeur absolue constitué par le nombre d'incréments. Ce signe peut être déterminé par comparaison entre la valeur initiale, c'est-à-dire zéro, et la première mesure effectuée : si le premier 1 est dû à une croissance du signal, le compteur s'incrémente normalement et le signe + sera donné par le moyen d'affichage; alors que si le premier 1 est dû à une variation décroissante du signal, le compteur verra ses entrées de comptage et de décomptage inversées par exemple. Le signe négatif - sera affiché. Les impulsions correspondant à une diminution du signal mesuré incrémentent alors les moyens 22 tandis que les impulsions correspondant à une augmentation du signal mesuré les décrémentent. Les moyens 22 peuvent être une suite de compteurs-décompteurs munis d'un dispositif de comparaison pour la détection de zéro, un micro-processeur ou tous autres circuits spécialisés. A titre d'exemple, la figure 5 montre une constitution possible du dispositif fournissant la mesure de la tension Vs sur un afficheur à sept segments, les moyens de comptage étant munis d'un convertisseur binaire-décimal. Sur la figure 5, où les organes correspondant à ceux déjà représentés sur la figure 1 sont désignés par le même numéro de référence, la voie 10a comprend des générateurs de référence 18a et 19a dont l'élément de stabilisation de tension est une diode Zener. Chacun des sommateurs 14a et 15a est formé par des amplificateurs opérationnels dont une entrée est à la masse par l'intermédiaire d'une résistance et dont l'autre entrée reçoit, par des résistances en parallèle, la tension de référence et la tension de sortie de l'échantillonneur-bloqueur 16. Les comparateurs sont constitués par des circuits disponibles dans le commerce, ainsi que la logique 20a, qui est une bascule RS classique.

La voie 10b peut avoir une constitution identique à celle de la voie 10a et, pour cette raison, n'est pas représentée en détail.

La logique 21 peut être constituée par une porte OU classique.

Lorsque l'on cherche à donner au dispositif un temps de réponse élevé, on aura intérêt à constituer les circuits en transistors bipolaires. On peut en particulier, lorsque le dispositif est constitué en circuits ECL, utiliser les composants suivants :

- sommateur : HA 4625
- comparateur : HA 4905
- bascules RS : CD 4044
- portes : CD 4001
- échantillonneur-bloqueur : HA 2425

- compteur-décompteur : ICM 7227
- afficheur : FND 500

A condition de disposer d'un échantillonneur-bloqueur suffisamment rapide, il est possible de simplifier le schéma de principe montré en figure 1 en omettant, dans chaque voie, la référence de zéro et les éléments qui lui sont associés.

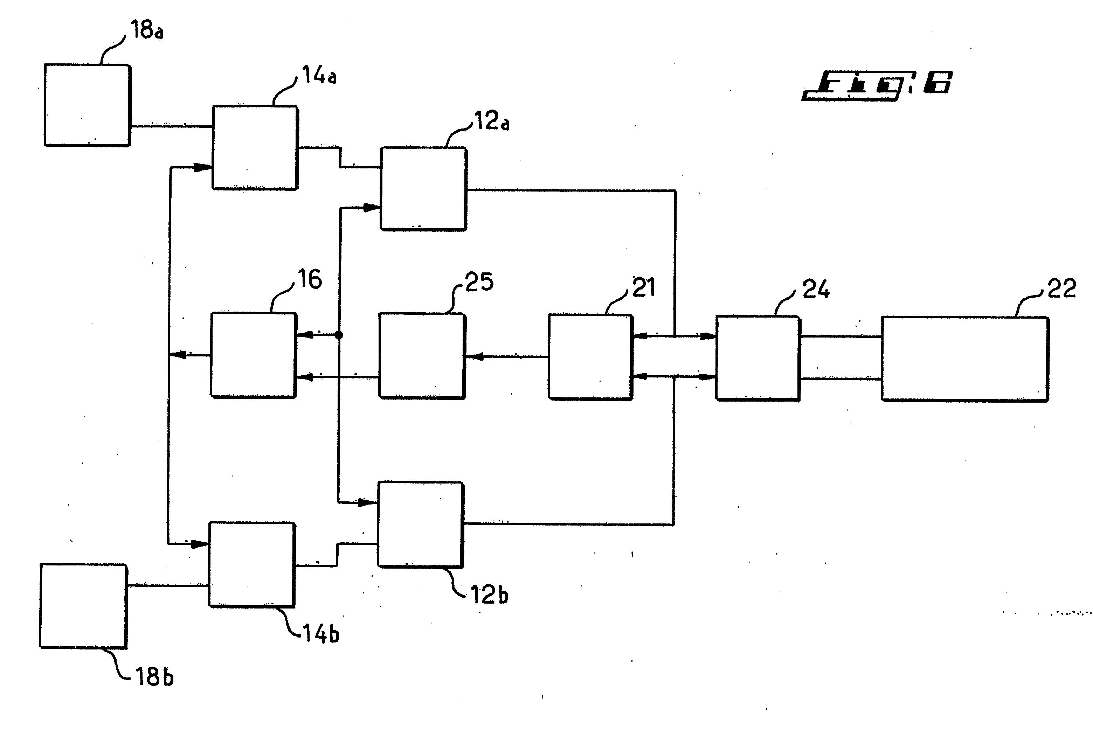

A titre d'exemple, la figure 6 montre un tel dispositif, où les éléments correspondant à ceux de la figure 1 sont désignés par le même numéro de référence. La sortie des comparateurs 12$\underline{a}$ et 12$\underline{b}$ est appliquée à l'une des entrées d'une porte OU 21 en même temps qu'à une entrée correspondante d'un circuit 24 qui fournit une impulsion calibrée d'incrémentation ou décrémentation du compteur -des compteurs 22 en réponse à chaque impulsion provenant du comparateur. La sortie de la porte OU 21 attaque un circuit de formation d'impulsions calibrées 25, qui peut être constitué par une bascule monostable.

L'impulsion calibrée de sortie du circuit 25 doit assurer l'échantillonnage de la tension d'entrée Vs d'échantillonneur 16 et sa mémorisation.

Le fonctionnement correct d'un tel dispositif impose que l'échantillonneur-bloqueur 16 ait une vitesse d'acquisition suffisante pour lui permettre de rattraper la tension VS appliquée sur son entrée analogique.

Il n'est pas nécessaire de décrire le fonctionnement du dispositif de la figure 6, étant donné qu'il découle immédiatement de celui de la figure 1.

Revendications

1.- Procédé de conversion A/N, caractérisé en ce qu'on compare un signal électrique analogique d'entrée à deux valeurs de référence invariables pendant la durée d'une comparaison, les deux valeurs étant obtenues à partir de la valeur analogique obtenue lors de la comparaison précédente respectivement par addition et soustraction d'une valeur fixe constituant un pas de quantification; on fait varier simultanément les deux valeurs par incréments ou décréments égaux au pas, suivant que le signal est égal à l'une ou l'autre des valeurs; on crée à chaque variation une impulsion affectée du signe + ou - suivant celle des valeurs qui est atteinte; et on totalise algébriquement en permanence le nombre des impulsions.

2.- Dispositif de conversion A/N d'un signal électrique, caractérisé en ce qu'il comprend un échantillonneur-bloqueur (16) destiné à recevoir sur son entrée analogique (17) le signal analogique à numériser; des moyens de sommation de la tension de sortie de l'échantillonneur-bloqueur et de signaux de référence + $\Delta$ V et - $\Delta$ V respectivement; des moyens permettant de comparer, à la tension d'entrée, la somme de la tension de sortie de l'échantillonneur-bloqueur et des signaux de référence + $\Delta$ V ou - $\Delta$ V, constituant un pas de quantification: et des moyens logiques reliés aux moyens de comparaison, destinés à émettre une impulsion de mémorisation de la tension d'entrée par l'échantillonneur-bloqueur lorsque les moyens de comparaison constatent une égalité et, simultanément, à émettre une impulsion affectée du signe + ou du signe - suivant le cas.

3.- Dispositif suivant la revendication 2, caractérisé en ce qu'il comporte deux voies dont chacune comporte deux comparateurs, l'un des comparateurs (13$\underline{a}$, 13$\underline{b}$) étant connecté de façon à comparer la tension d'entrée à la somme de la tension de référence $\pm$ 0 et de la tension de sortie de l'échantillonneur-bloqueur et l'autre (12$\underline{a}$, 12$\underline{b}$) étant connecté pour comparer la tension d'entrée à la somme de la tension de sortie de l'échantillonneur-bloqueur et du pas + $\Delta$V ou - $\Delta$V suivant la voie.

4.- Dispositif suivant la revendication 3, caractérisé en ce que chaque comparateur est associé à un sommateur dont une entrée est reliée à la sortie de l'échantillonneur-bloqueur (16) et l'autre entrée est reliée à un générateur de tension fournissant une tension de valeur absolue égal au pas $\Delta$V ou une tension nulle, qui est compensation du décalage de tension du sommateur et du comparateur associés.

5.- Dispositif suivant la revendication 3 ou 4, caractérisé en ce que les moyens logiques comprennent, dans chaque voie, une bascule (20$\underline{a}$) dont les entrées logiques sont reliées au comparateur (12$\underline{a}$, 13$\underline{a}$) de la voie et comprennent de plus une porte (21) interposée entre les sorties des bascules et l'entrée de commande de l'échantillonneur-bloqueur (16).

6.- Dispositif suivant l'une quelconque des revendications 2 à 5, caractérisé en ce qu'il comprend un compteur-décompteur (22) de réception des impulsions.

7.- Dispositif suivant la revendication 2, caractérisé en ce qu'il comporte deux voies (10$\underline{a}$, 10$\underline{b}$) dont chacune comporte un seul comparateur (12$\underline{a}$, 12$\underline{b}$)

connecté de façon à comparer la tension d'entrée (Vs) à la somme du pas + $\Delta$V ou - $\Delta$V, suivant la voie de la tension de sortie de l'échantillonneur-bloqueur (16) dont l'entrée de commande est reliée à la sortie d'une logique (24, 25) attaquée par les sorties des comparateurs.

8.- Dispositif de convertion A/N d'un signal électrique, caractérisé en ce qu'il comprend :
- des moyens de mémorisation du signal précédemment numérisé, délivrant la valeur analogique de celui-ci sur les entrées de moyens de sommation (14 et 15); lesdits moyens de sommation étant montés pour faire la somme de la tension de sortie des moyens de mémorisation et de signaux de références $\pm$ $\Delta$V (18 et 19);
- des moyens de comparaison (12 et 13) pour comparer, à une tension d'entrée à numériser, ladite somme;
- des moyens logiques (20 et 21) reliés aux moyens de comparaison et permettant de commander les moyens de mémorisation et simultanément, d'émettre une impulsion affectée du signe + ou - vers des moyens de comptage.
- décomptage (22).

FIG. 1

Fig. 2

Fig. 3

Fig. 4

FIG.5

Fig.6

**Office européen des brevets**

**RAPPORT DE RECHERCHE EUROPEENNE**

## DOCUMENTS CONSIDERES COMME PERTINENTS

| Catégorie | Citation du document avec indication, en cas de besoin, des parties pertinentes | Revendication concernée |
|---|---|---|
| X | FR - A - 2 049 400 (CIT)<br><br>* page 1, ligne 34 à page 2, ligne 30; figures 1 et 2 * | 1,6 |
|  | US - A - 3 753 133 (SHUMATE)<br><br>* colonne 2, ligne 16 à colonne 4, ligne 53; figures 1 et 2 * | 1,2 |
| A | US - A - 3 588 885 (SCHAAL)<br><br>* colonne 4, lignes 25-47; figure 2 * | 1 |
| A | EP - A - 0 006 023 (MORGAN-SMITH)<br><br>* page 5, ligne 4 à page 7, ligne 10; figure 1 * | 1,2,4 |

**CLASSEMENT DE LA DEMANDE (Int. Cl. 3)**

H 03 K 13/02

**DOMAINES TECHNIQUES RECHERCHES (Int. Cl. 3)**

H 03 K 13/02
H 04 B 12/04
H 03 K 13/22

**CATEGORIE DES DOCUMENTS CITES**

X: particulièrement pertinent à lui seul
Y: particulièrement pertinent en combinaison avec un autre document de la même catégorie
A: arrière-plan technologique
O: divulgation non-écrite
P: document intercalaire
T: théorie ou principe à la base de l'invention
E: document de brevet antérieur, mais publié à la date de dépôt ou après cette date
D: cité dans la demande
L: cité pour d'autres raisons

&: membre de la même famille, document correspondant

Le présent rapport de recherche a été établi pour toutes les revendications

| Lieu de la recherche | Date d'achèvement de la recherche | Examinateur |
|---|---|---|
| La Haye | 21.01.1982 | GUIVOL |

OEB Form 1503.1  06.78